# EUROPEAN PATENT SPECIFICATION

(11) **EP 4 601 000 B1**
(45) Date of publication and mention of the grant of the patent: **21.01.2026**
(21) Application number: 24157119.9
(22) Date of filing: 12.02.2024
(51) Int. Cl.: H01L 23/373, C04B 37/00, C04B 37/02, H01L 23/14, H01L 23/538, H01L 23/36, H01L 25/07

(54) **POWER SEMICONDUCTOR MODULE ARRANGEMENT AND METHOD FOR PRODUCING THE SAME**
LEISTUNGSHALBLEITERMODULANORDNUNG UND VERFAHREN ZU DEREN HERSTELLUNG
ENSEMBLE MODULE SEMI-CONDUCTEUR DE PUISSANCE ET SON PROCÉDÉ DE FABRICATION

(43) Date of publication of application: 13.08.2025
(73) Proprietor: Infineon Technologies AG, 85579 Neubiberg (DE)
(72) Inventor: HAMADI, Thomas, 44135 Dortmund (DE); OTTO, Frederik, 59399 Olfen (DE); KÜHLE, Elmar, 59581 Warstein (DE)
(74) Representative: Westphal, Mussgnug & Partner, Patentanwälte mbB

(56) References cited:
- EP-A1- 2 661 156
- EP-A1- 2 669 941
- EP-A1- 3 547 352
- US-A- 5 561 321
- US-A1- 2011 005 810

## Description

### TECHNICAL FIELD

The instant disclosure relates to a power semiconductor module arrangement and to a method for producing such a power semiconductor module arrangement.

### BACKGROUND

Document EP 2 669 941 A1 discloses a circuit board including a ceramics substrate containing therein a nitride, a circuit wiring board joined to one surface of the ceramics substrate through a joining layer, and a metallic supporting member joined to the other surface of the ceramics substrate through a joining layer. The joining layer is a sintered body containing therein silver or copper, and an oxide layer is formed in a joining interface between the ceramics substrate and the sintered body. The oxide layer is composed of a polycrystalline layer on a side of the ceramics substrate, and is composed of an amorphous layer on a side of the sintered body.

Document EP 2 661 156 A1 discloses a circuit board including a holding member, a bonding layer, an insulating substrate, a bonding layer, and a circuit wiring board, which are sequentially stacked in this order. The bonding layers are sintered bodies containing metal, the insulating substrate is made of non-oxide ceramic, and oxide layers are formed on both surfaces of the insulating substrate.

Document US 2011/005810 A1 discloses an insulating substrate including an electrically insulative layer, a wiring layer formed on one side of the electrically insulative layer and formed of a spark plasma sintered body of an electrically conductive material powder, and a stress relaxation layer formed on the other side of the electrically insulative layer and formed of a spark plasma sintered body of an alloy powder or a mixed powder to be formed into a metal composite. The wiring layer is formed of a spark sintered body of a powder selected from the group consisting of an Al powder, a Cu powder, an Ag powder, and an Au powder. The stress relaxation layer is formed of a spark plasma sintered body of a powder selected from the group consisting of an Al-Si alloy powder, a mixed powder of a Cu powder and an Mo powder, a mixed powder of a Cu powder and a W powder, a mixed powder of an Al powder and an SiC powder, and a mixed powder of an Si powder and an SiC powder.

Power semiconductor module arrangements often include at least one substrate. A semiconductor arrangement including a plurality of controllable semiconductor elements (e.g., two or more IGBTs) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. At least some controllable semiconductor elements of the power semiconductor module arrangement perform a plurality of switching operations during the operation of the power semiconductor module arrangement. When performing many switching operations within a short period of time, for example, the controllable semiconductor elements generate heat. Heat that is generated during the operation of the power semiconductor module arrangement is mostly dissipated from the controllable semiconductor elements to the substrate and further through a base plate to a heat sink.

There is a need for a power semiconductor module arrangement in which heat can be effectively conducted away from the semiconductor elements, and which can be produced at low costs.

### SUMMARY

A power semiconductor module arrangement includes a substrate including a dielectric insulation layer and a metallization layer arranged on a first side of the dielectric insulation layer, a base plate, and a connection layer, wherein the connection layer is arranged between the substrate and the base plate and attaches the substrate to the base plate, the connection layer directly adjoins the base plate and a second side of the dielectric insulation layer, opposite the first side, and the connection layer includes a sinter paste and an adhesion promoter. The connection layer includes a first sublayer consisting of adhesion promoter and a second sublayer consisting of sinter paste, and the first sublayer is arranged such that it directly adjoins the dielectric insulation layer, and the second sublayer directly adjoins the first sublayer on a side opposite the dielectric insulation layer. The adhesion promoter includes or consists of titanium, chromium, or vanadium.

A method includes forming a connection layer, arranging a substrate on a base plate with the connection layer arranged between the substrate and the base plate, and performing a sintering process, thereby connecting the substrate to the base plate by means of the connection layer, wherein the substrate includes a dielectric insulation layer and a metallization layer arranged on a first side of the dielectric insulation layer, when the substrate is arranged on the base plate, the connection layer directly adjoins the base plate and a second side of the dielectric insulation layer, opposite the first side, and the connection layer includes a sinter paste and an adhesion promoter. Forming the connection layer includes forming a second sublayer consisting of sinter paste and forming a first sublayer consisting of adhesion promoter on a first surface of the second sublayer. The adhesion promoter includes or consists of titanium, chromium, or vanadium.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of a power semiconductor module arrangement according to embodiments of the disclosure.
Figure 3 is top view of a base plate with a substrate mounted thereon.
Figure 4 is a top view of a base plate with two substrates mounted thereon.
Figure 5 is a top view of a base plate with four substrates mounted thereon.
Figure 6 is a cross-sectional view of a power semiconductor module arrangement according to examples not falling under the scope of the claims.
Figure 7 is a cross-sectional view of a power semiconductor module arrangement according to further embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connectable pads and includes at least one semiconductor element with electrodes.

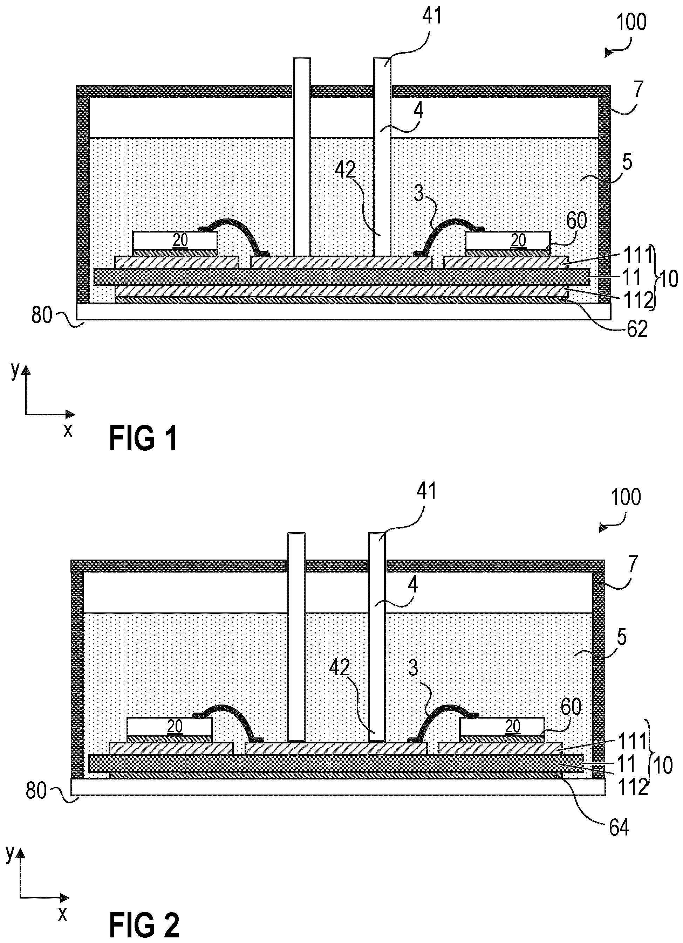

Referring to Figure 1, a cross-sectional view of a conventional power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AIN, ZrO₂, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, SiN or BN and may have a diameter of between about 1µm and about 50µm.

The substrate 10 is arranged in a housing 7. In the example illustrated in Figure 1, the substrate 10 is arranged on a base plate 80 which forms a base surface of the housing 7, while the housing 7 itself solely comprises sidewalls and, optionally, a top or cover. In some power semiconductor module arrangements 100, more than one substrate 10 is arranged on the same base plate 80 and within the same housing 7. The base plate 80 may comprise a layer of a metallic material such as, e.g., AlSiC, AlC, Al, MgSiC, or Cu. Other materials, however, are generally also possible.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. In some semiconductor modules 100, the second metallization layer 112 may be a structured layer. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example. The one or more substrates 10 may be mechanically and thermally connected to a base plate 80 by means of a connection layer 62. The connection layer 62 in conventional semiconductor modules 100 may be an electrically insulating adhesive layer, a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 provide an electrical connection between the inside and the outside of the housing 7. The terminal elements 4 may be electrically connected to the first metallization layer 111 with a second end 42, while a first end 41 of the terminal elements 4 protrudes out of the housing 7. The terminal elements 4 may be electrically contacted from the outside at their first end 41.

Arranging the terminal elements 4 centrally on the substrate 10 is only an example. According to other examples, terminal elements 4 may be arranged closer to or adjacent to the sidewalls of the housing 7. The second end 42 of a terminal element 4 may be electrically and mechanically connected to the substrate 10 by means of an electrically conductive connection layer (not specifically illustrated in Figure 1). Such an electrically conductive connection layer may be a solder layer, a layer of an electrically conductive adhesive, or a layer of a sintered metal powder, e.g., a sintered silver (Ag) powder, for example. Alternatively, the terminal elements 4 may also be coupled to the substrate by means of ultrasonic welding.

The power semiconductor module arrangement 100 may further include an encapsulant 5. The encapsulant 5 may consist of or include a cured silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their first ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. The encapsulant 5 is further configured to electrically insulate areas with different potentials (e.g., different sections of the first metallization layer 111) from each other.

The second metallization layer 112 of the substrate 10 is generally not required for the overall function of the semiconductor module 100. That is, the second metallization layer 112 generally does not conduct any currents during operation of the semiconductor module 100. Therefore, it is generally possible that the second metallization layer 112 be omitted altogether. It is, however, not possible to directly attach the dielectric insulation layer 11 of a substrate 10 to a base plate 80 by means of conventional sinter pastes. Omitting the second metallization layer, however, reduces the overall costs of a semiconductor module 100. Further, by omitting the second metallization layer 112, the overall thermal resistance Rth of the stack formed by the substrate 10 and the base plate 80 could be reduced, and the heat could be conducted away from the semiconductor bodies 20 to the base plate 80 more effectively.

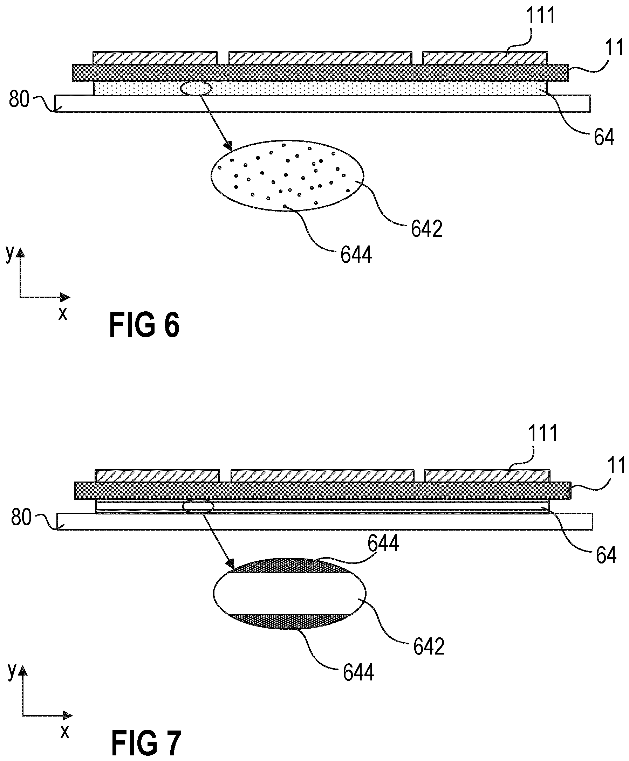

Now referring to Figure 2, a semiconductor module arrangement 100 according to embodiments of the disclosure comprises a substrate 10 comprising a dielectric insulation layer 11 and a metallization layer 111 arranged on a first side of the dielectric insulation layer 11. The substrate 10, however, does not comprise a second metallization layer 112. The semiconductor module 100 further comprises a base plate 80, and a connection layer 64. The connection layer 64 is arranged between the substrate 10 and the base plate 80 and attaches the substrate 10 to the base plate 80. As the substrate 10 does not comprise a second metallization layer 112, the connection layer 64 directly adjoins the base plate 80 and a second side of the dielectric insulation layer 11, opposite the first side. The connection layer 64 comprises a sinter paste 642 and an adhesion promoter 644 (see, e.g., Figure 6 and 7). Due to the adhesion promoter 644, the connection layer 64 not only adheres to the base plate 80, but also to the dielectric insulation layer 11 of the substrate 10.

As has been mentioned before, the dielectric insulation layer 11 may consist of or include one of the following materials: Al₂O₃; AIN; ZrO₂; SiC; BeO; BN; or Si₃N₄. The base plate 80 may consist of or include one of the following materials: AlSiC, AlC, Al, MgSiC, or Cu. The sinter paste 642 may comprise at least one of copper, and silver, for example, and the adhesion promoter 644 comprises or consists of titanium, chromium, or vanadium (e.g., vanadium nanoparticles).

According to examples not falling under the scope of the claims, the adhesion promoter 644 may be distributed within the sinter paste 642. This is schematically illustrated in Figure 6. Figure 6 schematically illustrates a cross-sectional view of a semiconductor module comprising a base plate 80, a substrate 10, and a connection layer 64. A section of the connection layer 64 is illustrated in an enlarged view in order to illustrate the adhesion promoter 644 distributed within the sinter paste 642. In order to produce the connection layer 64, the sinter paste 642 and the adhesion promoter 644 may be mixed together. The adhesion promoter 644, when mixed into the sinter paste 642, is also present on the surfaces of the connection layer 64. When the substrate 10 is arranged on the base plate 80 with the connection layer 64 arranged therebetween, and a sinter process is performed, the adhesion promoter 644 on the surfaces of the connection layer 64 reacts with the base plate 80 and with the dielectric insulation layer 11 of the substrate 10. In this way, the substrate 10 may be permanently connected to the base plate 80, even if no second metallization layer 112 is present. After mixing the sinter paste 642 with the adhesion promoter 644, the connection layer 64 may be formed on a surface of the base plate 80, and the substrate 10 may then be arranged on the connection layer 64. It is, however, also possible to form the connection layer 64 on the substrate (i.e. on the second side of the dielectric insulation layer 11) and to arrange the substrate 10 with the connection layer 64 formed thereon on the base plate 80.

Instead of distributing the adhesion promoter 644 within the sinter paste 642, however, according to embodiments of the disclosure, it is also possible that the connection layer 64 comprises a first sublayer consisting of adhesion promoter 644, a second sublayer consisting of sinter paste 642, and a third sublayer consisting of adhesion promoter 644, wherein the first sublayer is arranged such that it directly adjoins the base plate 80, the third sublayer is arranged such that it directly adjoins the dielectric insulation layer 11, and the second sublayer is arranged between and directly adjoins the first sublayer and the third sublayer. This is schematically illustrated in Figure 7 which schematically illustrates a cross-sectional view of a semiconductor module comprising a base plate 80, a substrate 10, and a connection layer 64. A section of the connection layer 64 is illustrated in an enlarged view in order to illustrate the first, second, and third sublayers.

A connection layer 64 comprising different sublayers may be formed in any suitable way. According to one example, the connection layer 64 may be formed by forming the second sublayer consisting of sinter paste, forming the first sublayer consisting of adhesion promoter on a first surface of the second sublayer, and forming the third sublayer consisting of adhesion promoter on a second surface of the second sublayer, opposite the first surface. The connection layer 64 comprising the first, second, and third sublayers may then be arranged between the substrate 10 and the base plate 80 (e.g., as a prefabricated foil). According to another example, the first sublayer is formed on the base plate 80, and the second sublayer is subsequently formed on the first sublayer. The third sublayer may then be formed on the second sublayer, thereby forming a layer stack (connection layer 64) comprising the first sublayer, the second sublayer, and the third sublayer on the base plate 80. Alternatively, such a layer stack (connection layer 64) may be formed on the dielectric insulation layer 11, and the substrate 10 with the connection layer 64 formed thereon can then be arranged on the base plate 80. According to an even further example, the first sublayer may be formed on the base plate 80, and the third sublayer may be formed on the substrate 10. The second sublayer in this example can either be formed on the first sublayer or on the third sublayer, before arranging the substrate 10 on the base plate 80. That is, the connection layer 64, comprising the first sublayer, the second sublayer, and the third sublayer is completed when the substrate 10 is arranged on the base plate 80.

According to yet another embodiment, the insulation layer 11 consists of two sublayers. In this example, a first sublayer comprises an adhesion promoter 644 and the second sublayer comprises a sinter paste 642. In some cases, depending upon the material from which the base plate 80 is made, the sublayer of sinter paste 642 can establish a secure bond with the baseplate 80 without need for a third sublayer of adhesion promoter 644. Where a copper base plate 80 is used, for example, a third sublayer of adhesion promoter 644 may not be necessary.

A substrate 10 and a base plate 80 generally have different coefficients of thermal expansion, CTE. A dielectric insulation layer 11 consisting of AIN, for example, has a CTE of about 4 x 10⁻⁶ °C⁻¹. A base plate 80 consisting of Cu, for example, has a CTE of about 17 x 10⁻⁶ °C⁻¹. Generally speaking, the dielectric insulation layer 11 has a first coefficient of thermal expansion, CTE1, and the base plate 80 has a second coefficient of thermal expansion, CTE2, that is different from the first CTE1. The connection layer 64 may have a third coefficient of thermal expansion, CTE3, wherein CTE1 < CTE3 < CTE2. For example, the connection layer 64 may have a third coefficient of thermal expansion CTE3 of between 4 x 10⁻⁶ °C⁻¹ and 17 x 10⁻⁶ °C⁻¹. The CTE3 of the connection layer 64 depends on the specific composition of the connection layer 64. That is, by using different materials for the sinter paste 642 and the adhesion promoter 644, and by using different sinter paste 642 / adhesion promoter 644 ratios, the CTE3 of the resulting connection layer 64 may be individually adjusted.

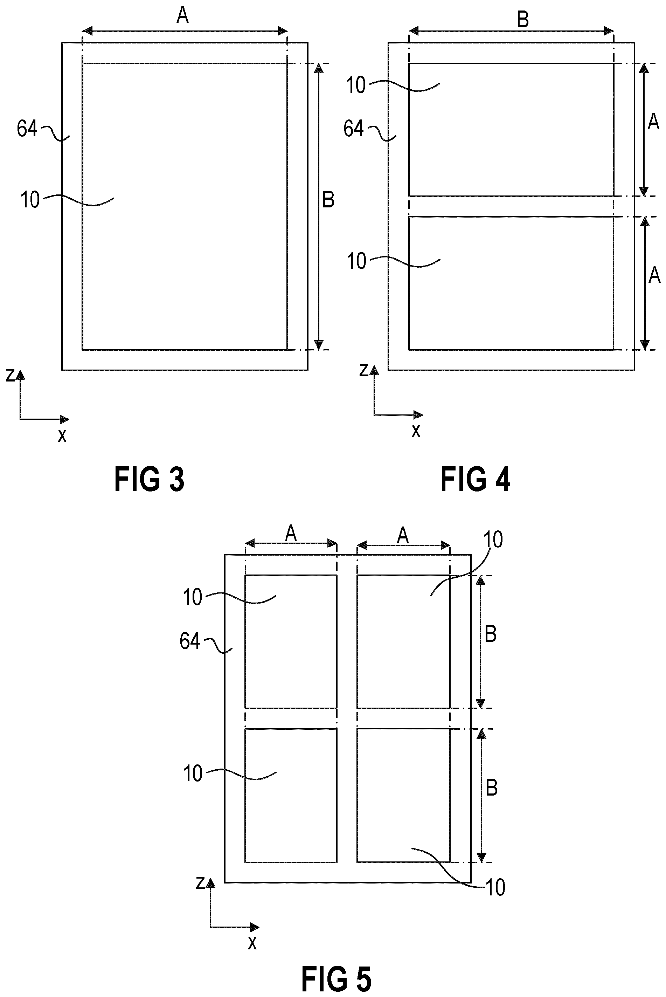

Generally, substrates 10 of any size can be used in the semiconductor modules described herein. In some semiconductor modules 100, only one (exactly one / not more than one) substrate 10 is arranged on a base plate 80. This is schematically illustrated in Figure 3. In other semiconductor modules 100, more than one substrate 10 can be arranged on a single base plate 80. A semiconductor module comprising two substrates 10 arranged on a base plate 80 is schematically illustrated in Figure 4, and a semiconductor module 100 comprising four substrates 10 arranged on a base plate 80 is schematically illustrated in Figure 5. Any other number of substrates 10 on a base plate 80 is generally possible. Each of the one or more substrates 10 illustrated in Figures 3, 4 and 5 has a rectangular shape. Other shapes, however, are generally also possible. The substrates 10, for example, may also have rounded corners. Each of the one or more substrates 10 has a width A in a first horizontal direction, and a length B in a second horizontal direction perpendicular to the first horizontal direction. The one or more substrates 10 arranged on the base plate 80 may be comparably large substrates 10, having a width A of at least 30 millimeters, and a length B of at least 40 millimeters, for example. The advantages of directly mounting the dielectric insulation layer 11 to a base plate 80 and omitting the second metallization layer 112 (improved Rth, reduced thickness of layer stack formed by substrate 10, connection layer 64, and base plate 80, and reduced overall costs of semiconductor module) become even more significant for larger substrates 10. However, it is generally also possible to arrange smaller substrates 10 to a base plate 80 in the way described above.

A method according to embodiments of the disclosure comprises forming a connection layer 64, arranging a substrate 10 on a base plate 80 with the connection layer 64 arranged between the substrate 10 and the base plate 80, and performing a sintering process, thereby connecting the substrate 10 to the base plate 80 by means of the connection layer 64, wherein the substrate 10 comprises a dielectric insulation layer 11 and a metallization layer 111 arranged on a first side of the dielectric insulation layer 11, wherein, when the substrate 10 is arranged on the base plate 80, the connection layer 64 directly adjoins the base plate 80 and a second side of the dielectric insulation layer 11, opposite the first side, and the connection layer 64 comprises a sinter paste 642 and an adhesion promoter 644.

Forming the connection layer 64 may comprise mixing the sinter paste 642 with the adhesion promoter 644. After mixing the sinter paste 642 with the adhesion promoter 644, the connection layer 64 may either be formed on a surface of the base plate 80, or on the second side of the dielectric insulation layer 11.

Alternatively, forming the connection layer 64 may comprise forming a second sublayer consisting of sinter paste 642 and forming a first sublayer consisting of adhesion promoter 644 on a first surface of the second sublayer. Forming the connection layer 64 may further comprise forming a third sublayer on the second sublayer, such that the second sublayer is arranged between the first sublayer and the third sublayer. Irrespective of whether the connection layer 64 comprises two or three sublayers, the connection layer 64 in this example may be a prefabricated mat that may be arranged on a surface of the base plate 80 or on a surface of the dielectric insulation layer 11, before arranging the substrate 10 on the base plate 80.

Alternatively, forming the connection layer 64 may comprise forming a sublayer consisting of sinter paste 642 on the base plate 80, and forming a sublayer consisting of adhesion promoter 644 either on the second sublayer, or on the dielectric insulation layer 11 of the substrate 10 (connection layer 64 comprises two sublayers), or forming the connection layer 64 may comprise forming a sublayer consisting of adhesion promoter 644 on the base plate 80, subsequently forming a sublayer consisting of sinter paste 642 on the sublayer consisting of adhesion promoter 644, and forming a further sublayer consisting of adhesion promoter 644 either on the sublayer consisting of sinter paste 642, or on the dielectric insulation layer 11 of the substrate 10 (connection layer 64 comprises three sublayers).

## Claims

1. A semiconductor module arrangement comprising:
a substrate (10) comprising a dielectric insulation layer (11) and a metallization layer (111) arranged on a first side of the dielectric insulation layer (11);
a base plate (80); and
a connection layer (64), wherein
the connection layer (64) is arranged between the substrate (10) and the base plate (80) and attaches the substrate (10) to the base plate (80),
the connection layer (64) directly adjoins the base plate (80) and a second side of the dielectric insulation layer (11), opposite the first side,
the connection layer (64) comprises a sinter paste (642) and an adhesion promoter (644),
the connection layer (64) comprises a first sublayer consisting of adhesion promoter (644) and a second sublayer consisting of sinter paste (642), and wherein the first sublayer is arranged such that it directly adjoins the dielectric insulation layer (11), and the second sublayer directly adjoins the first sublayer on a side opposite the dielectric insulation layer (11), and
the adhesion promoter (644) comprises or consists of titanium, chromium, or vanadium.

2. The semiconductor module arrangement of claim 1, wherein the connection layer (64) further comprises a third sublayer consisting of adhesion promoter (644), and wherein the third sublayer directly adjoins the second sublayer such that the second sublayer is arranged between the first sublayer and the third sublayer.

3. The semiconductor module arrangement of any of claims 1 or 2, wherein the sinter paste (642) comprises at least one of copper, and silver.

4. The semiconductor module arrangement of any of the preceding claims, wherein the dielectric insulation layer (11) consists of or includes one of the following materials: Al₂O₃; AIN; ZrO₂; SiC; BeO; BN; or Si₃N₄.

5. The semiconductor module arrangement of any of the preceding claims, wherein the base plate (80) consists of or includes one of the following materials: AlSiC, AlC, Al, MgSiC, or Cu.

6. The semiconductor module arrangement of any of the preceding claims, wherein
the substrate (10) has a width (A) in a first horizontal direction that is at least 30 millimeters; and
the substrate (10) has a length (B) in a second horizontal direction perpendicular to the first horizontal direction that is at least 40 millimeters.

7. The semiconductor module arrangement of any of the preceding claims, wherein the dielectric insulation layer (11) has a first coefficient of thermal expansion, CTE1, the base plate (80) has a second coefficient of thermal expansion, CTE2, that is different from the first CTE1, and the connection layer (64) has a third coefficient of thermal expansion, CTE3, and wherein CTE1 < CTE3 < CTE2.

8. A method comprising:
forming a connection layer (64);
arranging a substrate on a base plate (80) with the connection layer (64) arranged between the substrate (10) and the base plate (80); and
performing a sintering process, thereby connecting the substrate (10) to the base plate (80) by means of the connection layer (64), wherein
the substrate (10) comprises a dielectric insulation layer (11) and a metallization layer (111) arranged on a first side of the dielectric insulation layer (11);
when the substrate (10) is arranged on the base plate (80), the connection layer (64) directly adjoins the base plate (80) and a second side of the dielectric insulation layer (11), opposite the first side,
the connection layer (64) comprises a sinter paste (642) and an adhesion promoter (644),
forming the connection layer (64) comprises forming a second sublayer consisting of sinter paste (642) and forming a first sublayer consisting of adhesion promoter (644) on a first surface of the second sublayer, and
the adhesion promoter (644) comprises or consists of titanium, chromium, or vanadium.

9. The method of claim 8, wherein forming the connection layer (64) further comprises forming a third sublayer consisting of adhesion promoter (644) on the second sublayer, such that the second sublayer is arranged between the first sublayer and the third sublayer.

## Patentansprüche

1. Halbleitermodulanordnung, umfassend:
ein Substrat (10), das eine dielektrische Isolationsschicht (11) und eine Metallisierungsschicht (111) umfasst, die auf einer ersten Seite der dielektrischen Isolationsschicht (11) angeordnet ist;
eine Basisplatte (80); und
eine Verbindungsschicht (64), wobei
die Verbindungsschicht (64) zwischen dem Substrat (10) und der Basisplatte (80) angeordnet ist und das Substrat (10) an der Basisplatte (80) befestigt,
die Verbindungsschicht (64) direkt an die Basisplatte (80) und eine zweite Seite der dielektrischen Isolationsschicht (11) gegenüber der ersten Seite angrenzt,
die Verbindungsschicht (64) eine Sinterpaste (642) und einen Haftvermittler (644) umfasst,
die Verbindungsschicht (64) eine erste Teilschicht, die aus Haftvermittler (644) besteht, und eine zweite Teilschicht, die aus Sinterpaste (642) besteht, umfasst, und
wobei die erste Teilschicht so angeordnet ist, dass sie direkt an die dielektrische Isolationsschicht (11) angrenzt, und die zweite Teilschicht auf einer Seite gegenüber der dielektrischen Isolationsschicht (11) direkt an die erste Teilschicht angrenzt, und
der Haftvermittler (644) Titan, Chrom oder Vanadium umfasst oder daraus besteht.

2. Halbleitermodulanordnung nach Anspruch 1, wobei die Verbindungsschicht (64) ferner eine dritte Teilschicht umfasst, die aus Haftvermittler (644) besteht, und wobei die dritte Teilschicht direkt an die zweite Teilschicht angrenzt, so dass die zweite Teilschicht zwischen der ersten Teilschicht und der dritten Teilschicht angeordnet ist.

3. Halbleitermodulanordnung nach einem der Ansprüche 1 oder 2, wobei die Sinterpaste (642) mindestens eines von Kupfer und Silber umfasst.

4. Halbleitermodulanordnung nach einem der vorhergehenden Ansprüche, wobei die dielektrische Isolationsschicht (11) aus einem der folgenden Materialien besteht oder dieses beinhaltet: Al₂O₃; AIN; ZrO₂; SiC; BeO; BN; oder Si₃N₄.

5. Halbleitermodulanordnung nach einem der vorhergehenden Ansprüche, wobei die Basisplatte (80) aus einem der folgenden Materialien besteht oder dieses beinhaltet: AlSiC, AIC, Al, MgSiC oder Cu.

6. Halbleitermodulanordnung nach einem der vorhergehenden Ansprüche, wobei das Substrat (10) eine Breite (A) in einer ersten horizontalen Richtung aufweist, die mindestens 30 Millimeter beträgt; und
das Substrat (10) eine Länge (B) in einer zweiten horizontalen Richtung senkrecht zur ersten horizontalen Richtung aufweist, die mindestens 40 Millimeter beträgt.

7. Halbleitermodulanordnung nach einem der vorhergehenden Ansprüche, wobei die dielektrische Isolationsschicht (11) einen ersten Wärmeausdehnungskoeffizienten, CTE1, aufweist, die Basisplatte (80) einen zweiten Wärmeausdehnungskoeffizienten, CTE2, aufweist, der sich von dem ersten CTE1 unterscheidet, und die Verbindungsschicht (64) einen dritten Wärmeausdehnungskoeffizienten, CTE3, aufweist, und wobei CTE1 < CTE3 < CTE2.

8. Verfahren, das Folgendes umfasst:
Bilden einer Verbindungsschicht (64);
Anordnen eines Substrats auf einer Basisplatte (80), wobei die Verbindungsschicht (64) zwischen dem Substrat (10) und der Basisplatte (80) angeordnet ist; und Durchführen eines Sinterprozesses, wodurch das Substrat (10) mittels der Verbindungsschicht (64) mit der Basisplatte (80) verbunden wird, wobei das Substrat (10) eine dielektrische Isolationsschicht (11) und eine Metallisierungsschicht (111) umfasst, die auf einer ersten Seite der dielektrischen Isolationsschicht (11) angeordnet ist;
wenn das Substrat (10) auf der Basisplatte (80) angeordnet ist, die Verbindungsschicht (64) direkt an die Basisplatte (80) und eine zweite Seite der dielektrischen Isolationsschicht (11) gegenüber der ersten Seite angrenzt,
die Verbindungsschicht (64) eine Sinterpaste (642) und einen Haftvermittler (644) umfasst,
das Bilden der Verbindungsschicht (64) Bilden einer zweiten Teilschicht, die aus Sinterpaste (642) besteht, und Bilden einer ersten Teilschicht, die aus Haftvermittler (644) besteht, auf einer ersten Oberfläche der zweiten Teilschicht umfasst, und
der Haftvermittler (644) Titan, Chrom oder Vanadium umfasst oder daraus besteht.

9. Verfahren nach Anspruch 8, wobei das Bilden der Verbindungsschicht (64) ferner Bilden einer dritten Teilschicht, die aus Haftvermittler (644) besteht, auf der zweiten Teilschicht, so dass die zweite Teilschicht zwischen der ersten Teilschicht und der dritten Teilschicht angeordnet ist, umfasst.

## Revendications

1. Un agencement de module à semiconducteur comprenant :
un substrat (10) comprenant une couche (11) diélectrique isolante et une couche (111) de métallisation disposée sur une première face de la couche (11) diélectrique isolante ;
une plaque (80) de base ; et
une couche (64) de connexion, dans lequel
la couche (64) de connexion est disposée entre le substrat (10) et la plaque (80) de base et fixe le substrat (10) à la plaque (80) de base,
la couche (64) de connexion est adjointe directement à la plaque (80) de base et à une deuxième face de la couche (11) diélectrique isolante, opposée à la première face,
la couche (64) de connexion comprend une pâte (642) de frittage et un promoteur (644) d'adhérence,
la couche (64) de connexion comprend une première sous-couche consistant en un promoteur (644) d'adhérence et une deuxième sous-couche consistant en une pâte (642) de frittage, et dans lequel la première sous-couche est disposée de manière à être adjointe directement à la couche (11) diélectrique isolante, et de manière à ce que la deuxième sous-couche soit adjointe directement à la première sous-couche sur une face opposée de la couche (11) diélectrique isolante, et
le promoteur (644) d'adhérence comprend ou consiste en du titane, du chrome ou du vanadium.

2. L'agencement de module à semiconducteur de la revendication 1, dans lequel la couche (64) de connexion comprend en outre une troisième sous-couche consistant en du promoteur (644) d'adhérence, et dans lequel la troisième sous-couche est adjointe directement à la deuxième sous-couche, de manière à ce que la deuxième sous-couche soit disposée entre la première sous-couche et la troisième sous-couche.

3. L'agencement de module à semiconducteur de l'une quelconque des revendications 1 ou 2, dans lequel la partie (642) de frittage comprend au moins du cuivre et de l'argent.

4. L'agencement de module à semiconducteur de l'une quelconque des revendications précédentes, dans lequel la couche (11) diélectrique isolante consiste ou comprend l'un des matériaux suivants : Al₂O₃ ; AlN ; ZrO₂; SiC ; BeO ; BN ou Si₃N₄.

5. L'agencement de module à semiconducteur de l'une quelconque des revendications précédentes, dans lequel la plaque (80) de base consiste ou comprend l'un des matériaux suivants : AlSiC, AIC, AI, MgSiC ou Cu.

6. L'agencement de module à semiconducteur de l'une quelconque des revendications précédentes, dans lequel
le premier substrat (10) a une largeur (A) dans une première direction horizontale, qui est d'au moins 30 millimètres ; et
le substrat (10) a une longueur (B) dans une deuxième direction horizontale perpendiculaire à la première direction horizontale, qui est d'au moins 40 millimètres.

7. L'agencement de module à semiconducteur de l'une quelconque des revendications précédentes, dans lequel la couche (11) diélectrique isolante a un premier coefficient de dilatation thermique, CTE1, la plaque (80) de base a un deuxième coefficient de dilatation thermique, CTE2, qui est différent du premier CTE1, et la couche (64) de connexion a un troisième coefficient de dilatation thermique, CTE3, et dans lequel CTE1 < CTE3 < CTE2.

8. Un procédé comprenant :
former une couche (64) de connexion ;
disposer un substrat sur une plaque (80) de base en ayant la couche (64) de connexion disposée entre le substrat (10) et la plaque (80) de base ; et
effectuer une opération de frittage en connectant ainsi le substrat (10) à la plaque (80) de base au moyen de la couche (64) de connexion, dans lequel le substrat (10) comprend une couche (11) diélectrique isolante et une couche (111) de métallisation disposée sur une première face de la couche (11) diélectrique isolante ;
lorsque le substrat (10) est disposé sur la plaque (80) de base, la couche (64) de connexion est adjointe directement à la plaque (80) de base et à une deuxième face de la couche (11) diélectrique isolante, opposée à la première face,
la couche (64) de connexion comprend une pâte (642) de frittage et un promoteur (644) d'adhérence,
former la couche (64) de connexion comprend former une deuxième sous-couche consistant en de la pâte (642) de frittage et former une première sous-couche consistant en du promoteur (644) d'adhérence sur une première surface de la deuxième sous-couche, et
le promoteur (644) d'adhérence comprend ou consiste en du titane, du chrome ou du vanadium.

9. Le procédé de la revendication 8, dans lequel former la couche (64) de connexion comprend en outre une troisième sous-couche consistant en du promoteur (644) d'adhérence sur la deuxième sous-couche, de manière à ce que la deuxième sous-couche soit disposée entre la première sous-couche et la troisième sous-couche.
